# EUROPÄISCHE PATENTSCHRIFT

(11) **EP 2 802 048 B1**
(45) Veröffentlichungstag und Bekanntmachung des Hinweises auf die Patenterteilung: **04.06.2025**
(21) Anmeldenummer: 14166972.1
(22) Anmeldetag: 05.05.2014
(51) Int. Cl.: H02G 3/04, D03D 1/00, F16L 11/12

(54) **Schutzschlauch mit elektromagnetischer Abschirmung**
Protective hose with electromagnetic shielding
Tuyau isolant doté d'un blindage électromagnétique

(30) Priorität: 06.05.2013 DE 102013208250
(43) Veröffentlichungstag der Anmeldung: 12.11.2014
(73) Patentinhaber: Fränkische Industrial Pipes GmbH & Co. KG, 97486 Königsberg (DE)
(72) Erfinder: Peter Biermaier, CH - 9436 Balgach (CH)
(74) Vertreter: Weickmann & Weickmann PartmbB

(56) Entgegenhaltungen:
- EP-A1- 2 112 731
- EP-A2- 2 128 212
- EP-B1- 1 348 247
- WO-A1-01/42702
- WO-A2-03/013208
- WO-A2-2008/043948
- DE-A1- 4 116 591
- JP-A- 2004 190 194
- JP-A- H1 064 353
- JP-A- H1 070 808
- US-A- 4 375 009
- US-A- 4 376 229
- US-A- 4 452 279
- US-A1- 2011 083 879
- US-A1- 2012 148 772

## Beschreibung

Die Erfindung betrifft einen in seinem Durchmesser elastisch aufweitbaren Schutzschlauch nach dem Oberbegriff des Anspruchs 1.

Derartige Schutzschläuche werden beispielsweise verwendet, um elektrische Leitungen vor dem Einfluss von elektromagnetischen Störquellen zu schützen. Ein Anwendungsgebiet ist beispielsweise die Kraftfahrzeugtechnik, insbesondere die Verkabelung von Kraftfahrzeugen. Dabei tritt häufig die Situation auf, dass der Schutzschlauch über einen Stecker gezogen werden muss, der nicht lösbar mit der elektrischen Leitung bzw. dem elektrischen Kabel verbunden ist. Wichtig ist in diesem Zusammenhang die Rückstellfähigkeit des Schutzschlauchs, d.h. dessen Vermögen, sich nach Passieren des Steckers wieder auf einen an den Durchmesser der Leitung bzw. des Kabels angepassten Durchmesser zusammenziehen zu können.

Ein Schutzschlauch ist beispielsweise aus der EP 1 348 247 B1 bekannt. Der bekannte Schutzschlauch ist als Geflechtschlauch ausgebildet, wobei neben den Fäden aus elektrisch leitfähigem Material auch Kunststofffäden verarbeitet wurden, welche nach dem Aufweiten des Schutzschlauchs für die elastische Rückstellung des Schutzschlauchs sorgen. In der Praxis hat sich jedoch gezeigt, dass der bekannte Schutzschlauch in Längenabschnitten, in denen er im verbauten Zustand aufgeweitet bleibt, beispielsweise in einem einem Stecker unmittelbar benachbarten Längenabschnitt, ein geringeres Abschirmungsvermögen gegenüber elektromagnetischen Störeffekten aufweist als in Längenabschnitten, in denen er sich wieder vollständig zusammenziehen konnte.

Ferner ist aus dem Dokument WO-A-03013208, ein Geflecht bekannt, welches eine erste und eine zweite Gruppe von Fasern umfasst, die jeweils in einer ersten und zweiten Richtung angeordnet sind. Eine der beiden Gruppen von Fasern ist dabei mit einer Metallfolie umwickelt, so dass das Geflecht elektromagnetische Abschirmeigenschaften aufweisen kann. Aufgrund der Anordnung der Fasern bzw. der Gruppen von Fasern weist das Geflecht auch elastische Eigenschaften auf.

Des Weiteren ist aus dem Dokument JP-H-1064353 A ein Schutzmantel bekannt, welcher elektromagnetische Abschirmeigenschaften aufweist. Der Schutzmantel umfasst eine magnetische und eine leitende Schicht. Die magnetische Schicht ist dabei aus einem Mix aus Elastomer mit magnetischem Pulver aufgebaut. Der hierin offenbarte Schutzmantel ist an einer Seite parallel zu seiner Längsachse geschlitzt.

Aus der US-A-4375009 ist ein Schutzschlauch mit elektromagnetischer Abschirmung bekannt, in welchen zu isolierende Kabel eingeführt werden können, oder welcher um zu isolierende Kabel herum gestrickt oder/und geflochten werden kann.

Darüber hinaus seien die Dokumente JP-A-2004190194, WO-A-0142702, US-A-2012148772, EP-A-2112731, JP-H-1070808 A, EP 1 348 247 B1, WO 2008/043 948 A2, US 4 376 229 A, US 2011/083 879 A1, EP 2 128 212 A2, DE 41 16 591 A1 und US 4 452 279 A erwähnt.

Es ist daher Aufgabe der vorliegenden Erfindung, den gattungsgemäßen Schutzschlauch derart weiterzubilden, dass er im aufgeweiteten Zustand ein verbessertes Abschirmungsvermögen gegenüber elektromagnetischen Störeffekten, insbesondere elektromagnetischer Störstrahlung, zumindest in einem Frequenzbereich von 10 kHz bis 30 MHz, aufweist.

Diese Aufgabe wird erfindungsgemäß durch einen Schutzschlauch gemäß Anspruch 1 gelöst. Die Ummantelung aus dem elastisch dehnbaren Material sorgt dabei dafür, dass die Fäden, aus denen der Schutzschlauch hergestellt ist, an den Stellen, an denen sie sich gegenseitig berühren, beim Aufweiten zuverlässig miteinander in Kontakt gehalten bleiben, so dass die durch die elektromagnetischen Störeffekte induzierten Wirbelströme unabhängig vom Aufweitungszustand des Schutzschlauchs im Wesentlichen ungehindert zirkulieren und somit ihre Abschirmungswirkung im Wesentlichen ungehindert entfalten können. Insbesondere zeigt eine EMV-Prüfung (EMV - elektromagnetische Verträglichkeit), dass die Abschirmung gegenüber elektromagnetischer Strahlung einer Frequenz von 10 kHz bis 30 MHz sowohl im nicht aufgeweiteten als auch im aufgeweiteten Zustand des Schutzschlauchs annähernd identisch ist.

Als elastisch dehnbares Material kann beispielsweise Silikon verwendet werden. Grundsätzlich kann aber auch an den Einsatz von Polyurethan, Materialien auf Polyurethanbasis, Naturkautschuk oder allgemein Elastomere gedacht werden. Als Silikon kann beispielsweise das unter der Handelsbezeichnung Elastosil ^{®} LR 3003/20 von der Wacker Chemie AG erhältliche Silikon verwendet werden.

An dieser Stelle sei darauf hingewiesen, dass das Vorsehen einer Ummantelung aus einem elastisch dehnbaren Material bei Schutzschläuchen mit ausschließlich mechanischer oder/und thermischer Schutzfunktion an sich bekannt ist. Da diese Schutzschläuche ausschließlich aus Fäden ohne jegliche elektrische Leitfähigkeit hergestellt sind, legen diese Schutzschläuche dem Fachmann aber nicht nahe, dass durch eine derartige Ummantelung auch die Abschirmungseigenschaften gegenüber elektromagnetischen Störeffekten verbessert werden könnten.

Erfindungsgemäß ist der Schutzschlauch ein geflochtener Schutzschlauch. Beispielhaft wird ferner ein gestrickter (nicht-erfindungsgemäßer) Schutzschlauch für eine derartige Verwendung beschrieben werden.

Im Falle eines Geflechts kann die Aufweitbarkeit durch den so genannten Schereneffekt der geflochtenen Fäden erzielt werden. Dabei ist gemäß dem ersten erfinderischen Aspekt ein flacher Flechtwinkel, d.h. ein relativ zur Längserstreckungsrichtung des Schutzschlauchs gemessener Flechtwinkel von weniger als 45°, vorzugsweise weniger als als 30°, vorgesehen.

Hingegen kann im Falle eines Gestricks die Aufweitbarkeit dadurch bereitgestellt werden, dass man das Gestrick beim Ummanteln mit dem elastisch dehnbaren Material in Längserstreckungsrichtung des Schutzschlauchs unter Zugspannung gesetzt hält, so dass die Maschen des Gestricks gestreckt sind. Auf diese Weise kann die gestreckte Gestalt der Maschen durch die elastisch dehnbare Ummantelung quasi "eingefroren" werden. Gemäß dem zweiten erfinderischen Aspekt verlaufen die in Längsrichtung des Schutzschlauchs verlaufenden Maschenabschnitte zueinander im Wesentlichen parallel. Aufgrund der elastischen Dehnbarkeit der Ummantelung kann der Schlauch aber aufgeweitet werden, ohne dass sich die Maschen relativ zueinander verschieben, weil die Ummantelung die einander an den Maschenpunkten berührenden Fadenabschnitte dort fixiert.

Im Hinblick auf die Dehnbarkeit des gestrickten Schutzschlauchs ist es erfindungsgemäß vorgesehen, dass im nicht aufgeweiteten Zustand des Schutzschlauchs das Verhältnis der Länge der in Längsrichtung des Schutzschlauchs verlaufenden Maschenabschnitten zur Länge der in Umfangsrichtung des Schutzschlauchs verlaufenden Maschenabschnitte wenigstens 2 beträgt. Vorzugsweise kann dieses Verhältnis wenigstens 3, noch bevorzugter wenigstens 5 betragen.

Gemäß der Erfindung ist vorgesehen, dass wenigstens einer der Fäden, vorzugsweise alle Fäden, eine Mehrzahl von Fasern umfasst, von denen wenigstens einige, vorzugsweise alle, aus elektrisch leitfähigem Material hergestellt sind. Das Vorsehen einer Mehrzahl von Fasern aus elektrisch leitfähigem Material pro Faden hat den Vorteil, dass sich die Fasern zweier aneinander anliegender Fäden derart anordnen, dass beide Fäden eine abgeflachte Querschnittsfläche aufweisen. Hierdurch erhöht sich die Anzahl der einander berührenden Fasern, was sich wiederum auf das Zirkulieren der durch die elektromagnetischen Störeffekte induzierten Wirbelströme und somit auf die Abschirmwirkung positiv auswirkt. Vorzugsweise werden die Fasern infolge der Abflachung nebeneinander angeordnet. Sind alle Fasern aller Fäden aus elektrisch leitfähigem Material ausgebildet, so ergibt sich zudem die bestmögliche Abschirmwirkung. Die Ummantelung aus dem elastisch dehnbaren Material sorgt bei der Aufdehnung des Schutzschlauchs dafür, dass sich die Fasern der Fäden nicht zusammenhäufen können, sondern dass die Nebeneinanderanordnung der Fasern der Fäden und somit die Güte der Abschirmwirkung aufrechterhalten bleibt. Zusätzlich oder alternativ zu Fasern mit kreisscheibenförmiger Querschnittsfläche können zur Verbesserung der Abschirmwirkung auch Fasern mit abgeflachtem Querschnitt verwendet werden.

An dieser Stelle sei angemerkt, dass eine aus einem elektrisch leitfähigen Material hergestellte Faser auch als ''Draht" bezeichnet werden kann. Im Zusammenhang mit der vorliegenden Erfindung wird aber gleichwohl der Begriff "Faser" verwendet werden.

Zur Verbesserung der Abschirmwirkung ist es ferner vorteilhaft, wenn wenigstens ein Faden, vorzugsweise jeder Faden, oder/und wenigstens eine Faser, vorzugsweise jede Faser, aus Kupfer, vorzugsweise verzinntem oder versilbertem Kupfer, hergestellt ist bzw. sind. Kupfer ist dabei wegen seiner hohen Leitfähigkeit vorteilhaft. Und durch das Verzinnen kann die Korrosionsbeständigkeit oder/und die Lötbarkeit des Schutzschlauchs den. Im Hinblick auf eine hohe Leitfähigkeit können die Kupferfasern aber auch versilbert sein.

Um die Aufweitbarkeit des Schutzschlauchs verbessern zu können, ist es gemäß der Erfindung so, dass die Reißdehnbarkeit des elastisch dehnbaren Materials mehr als 200%, vorzugsweise mehr als 500%, noch bevorzugter mindestens 800%, beträgt. Die "Reißdehnbarkeit" wird dabei dadurch bestimmt, dass man einen Materialstreifen vorbestimmter Länge solange dehnt, bis er reißt. Die Länge, die der Materialstreifen aufweist unmittelbar bevor er reißt, geteilt durch die vorbestimmte Länge ergibt einen dimensionslosen, als "Reißdehnbarkeit" bezeichneten Wert. Der Wert der Reißdehnbarkeit des elastisch dehnbaren Materials kann in Abhängigkeit von der Dehnbarkeit des Schutzschlauchs, insbesondere des Geflechts oder des Gestricks, gewählt werden.

Ist die Ummantelung, wie erfindungsgemäß vorgeschlagen, durchbrechungsfrei ausgebildet, so verfügt der Schutzschlauch zum einen bei Aufweitung über sehr gute Rückstelleigenschaften, da sich die Ummantelung nach Aufweitung vollflächig wieder zusammenzieht. Zum anderen kann die durchbrechungsfreie Ummantelung aber auch einen Schutz vor Feuchtigkeit bereitstellen. Darüber hinaus stellt eine durchbrechungsfreie Ummantelung eine gleichmäßige Aufdehnung des Schutzschlauchs sicher. Schließlich ermöglicht sie eine durchgehende Einfärbung des Schutzschlauchs. Eine derartige durchgehende Einfärbung, insbesondere in Signalorange, ist beispielsweise in Elektro- und Hybridfahrzeugen für die den Antriebsstrom führenden Kabel erforderlich.

Erfindungsgemäß haftet die Ummantelung den Fäden zumindest an deren der Außenumfangsfläche des Schlauches zugewandter Seite an. Ein vollständiges Einbetten der Fäden bzw. Fasern in das elastisch dehnbare Material ist nicht erforderlich. Vielmehr genügt es, die Fäden bzw. Fasern so miteinander zu verkleben, dass sie beim Aufweiten des Schutzschlauchs miteinander in Kontakt gehalten bleiben. Dies kann auch nur von der Außenseite der Fäden bzw. Fasern her erfolgen.

Die Erfindung wird im Folgenden anhand der beigefügten Zeichnung an einem Ausführungsbeispiel näher erläutert werden. Es stellt dar:
- Figur 1: eine teilweise geschnittene Darstellung eines erfindungsgemäßen Schutzschlauchs;
- Figur 2: eine schematische Darstellung eines Messaufbaus zur Bestimmung der Schirmdämpfung des in Figur 1 dargestellten Schutzschlauchs;
- Figuren 3 und 4: die Messergebnisse der Schirmdämpfungsmessung an dem in Figur 1 dargestellten Schutzschlauch unter Verwendung des in Figur 2 dargestellten Messaufbaus, und zwar im ungedehnten Zustand (Figur 3) und im gedehnten Zustand (Figur 4); und
- Figur 5: eine grobschematische Darstellung eines Gestricks, das zur Herstellung einer weiteren Ausführungsform eines erfindungsgemäßen Schutzschlauchs verwendet werden kann.

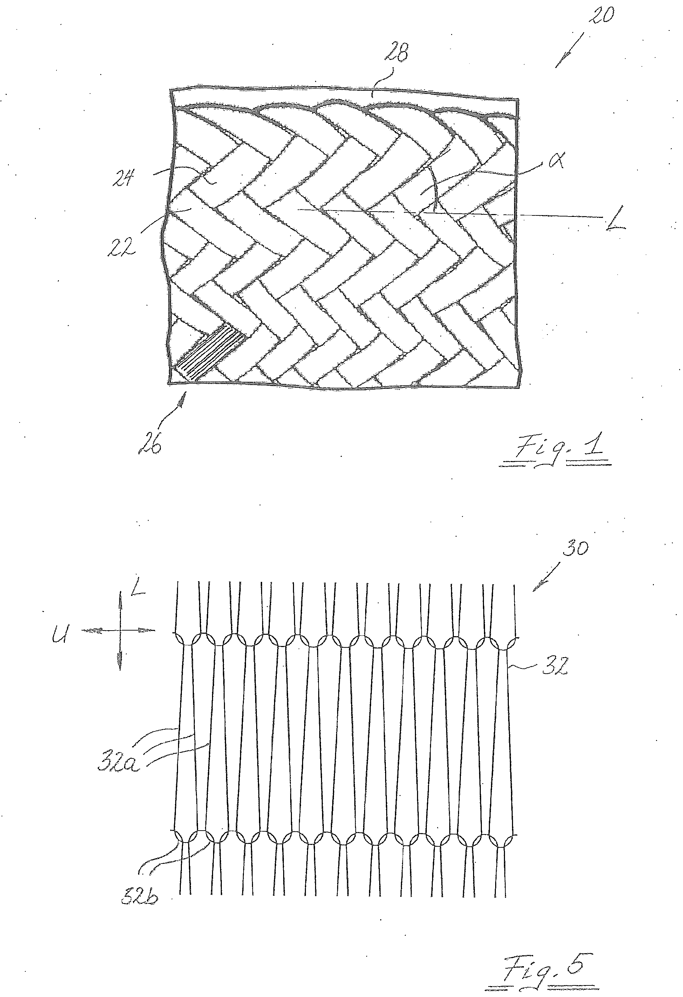

In Figur 1 ist ein als Geflechtschlauch ausgebildeter Schutzschlauch allgemein mit 20 bezeichnet. Der Geflechtschlauch 20 ist aus einer Mehrzahl von einander kreuzenden Fäden 22 und 24 gebildet. Dabei beträgt der relativ zur Längserstreckungsrichtung L des Schutzschlauchs 20 gemessene Flechtwinkel α der Fäden 22, 24 höchstens 45°. Wie in Figur 1 bei 26 angedeutet, umfasst jeder der Fäden 22, 24 sechzehn Fasern bzw. Drähte aus verzinntem Kupfer mit einem Durchmesser von jeweils 0,10 mm. Im nicht aufgeweiteten Zustand des Schutzschlauchs 20 beträgt dessen Durchmesser etwa 20 mm. Auf den Schutzschlauch 20 wird eine zwischen etwa 0,5 mm und etwa 1,0 mm dicke Schicht 28 aus dem unter der Handelsbezeichnung Elastosil ^{®} LR 3003/20 von der Wacker Chemie AG erhältlichen Silikon aufgetragen. Der so hergestellte Schutzschlauch 20 ist in einem Temperaturbereich von -40°C bis +150°C für mindestens 3000 Stunden und in einem Temperaturbereich von -40°C bis +175°C für mindestens 1500 Stunden temperaturbeständig.

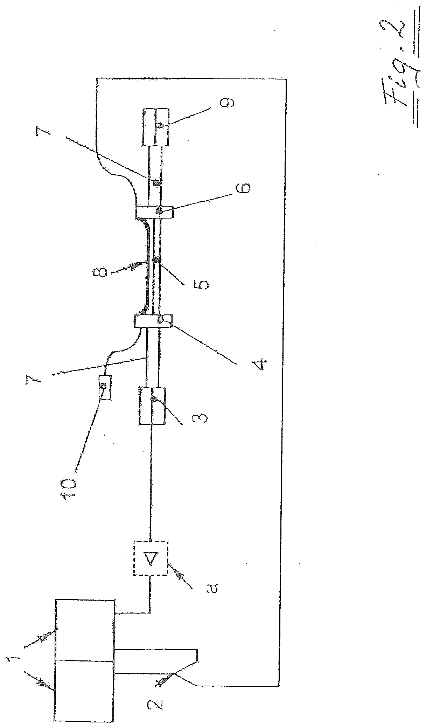

Das Abschirmvermögen dieses Schutzschlauchs 20 kann durch das Maß der so genannten Schirmdämpfung beschrieben werden. Diese Schirmdämpfung ist das Verhältnis einer Störleistung im Raum zur maximal hervorgerufenen Leistung innerhalb der/des vom Schutzschlauch umgebenen Leitung/Kabels. Genauer gesagt ist die Schirmdämpfung das Verhältnis des Werts der elektrische Feldstärke außerhalb des Schlauchs zum Wert der elektrischen Feldstärke innerhalb des Schlauchs. Sie wird in der Einheit "dB" angegeben. Die Schirmdämpfung kann nach dem so genannten Paralleldraht-Verfahren nach der VG 95214-6 mit dem in Figur 2 dargestellten Aufbau bestimmt werden.

Als Prüfling 5 wurde im vorliegenden Fall der Innenleiter eines Koaxialkabels verwendet, dessen Abschirmung zuvor entfernt und durch das erfindungsgemäße Schutzrohr ersetzt worden war. Der Prüfling 5 wurde an zwei Messaufnahmen 4 und 6 angeschlossen, die im konkreten Versuchsaufbau von zwei Messingplatten mit aufgelöteten N-Buchsen gebildet waren. Der Innenleiter des Koaxialkabels verlief durch die N-Buchsen hindurch, während das Schutzrohr mittels Schraubschellen mit den N-Buchsen elektrisch leitend verbunden wurde. Zwischen den Messaufnahmen 4 und 6 verlief ferner ein als Störquelle dienender Paralleldraht 8.

Die Störleistung wurde dem Paralleldraht 8 von einem Netzwerkanalysator 1 (HF-Generator der Fa. Rohde & Schwarz, Typ SMA100C, Kenn-Nr. 2.81.01, kalibriert 06/2012; und Messempfänger der Fa. Rohde & Schwarz, Typ ESU8, Kenn-Nr. 2.70.05, kalibriert 09/2011) über einen Leistungsteiler 2 und die Messaufnahme 6 zugeführt. Zudem war der Paralleldraht 8 an der Messaufnahme 4 mit einer Abschlussimpedanz 10 (Fa. Spinner, Typ 50Ω/25W, Kenn-Nr. 5.10.01, kalibriert 10/2012) verbunden. Der Prüfling 5 war an der Messaufnahme 6 über ein Schirmrohr 7 mit einem schirmenden Gehäuse 9 verbunden, das mit einer Abschlussimpedanz (Fa. Rosenberger, Typ 50Ω/0,25W, Kenn-Nr. 5.10.16, kalibriert 10/2012) versehen war, und an der Messaufnahme 4 über ein weiteres Schirmrohr 7 mit einem schirmenden Gehäuse 3, über das das im Prüfling 5 induzierte Signal dem Netzwerkanalysator 1 zugeführt wurde. Zwischen dem schirmenden Gehäuse 3 und dem Netzwerkanalysator kann erforderlichenfalls ferner ein Leistungsverstärker a vorgesehen werden.

Die Messungen erfolgten auf einem Holztisch in einer geschirmten Messkabine. Die Schirmdämpfung wurde im Frequenzbereich von 10 kHz bis 30 MHz durchgeführt.

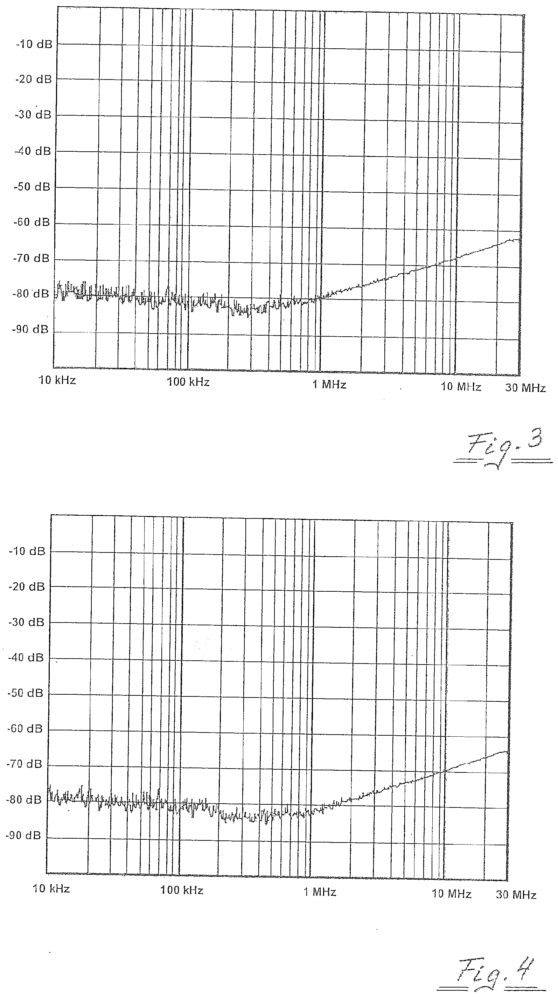

Zum einen wurde die Messung im ungedehnten Grundzustand des erfindungsgemäßen Schutzrohrs durchgeführt, in dem er einen Durchmesser von 20 mm aufwies. Das entsprechende Messergebnis ist in Figur 3 dargestellt. Und zum anderen wurde die Messung im aufgeweiteten Zustand des erfindungsgemäßen Schutzrohrs durchgeführt, in dem er einen Durchmesser von 45 mm aufwies. Das entsprechende Messergebnis ist in Figur 4 dargestellt. Wie man leicht erkennt, unterscheiden sich die beiden Messergebnisse praktisch nicht, was bedeutet, dass die Abschirmwirkung des erfindungsgemäßen Schutzschlauchs im ungedehnten Grundzustand und dessen Abschirmwirkung im gedehnten Zustand im Wesentlichen identisch sind.

In Figur 5 ist ein Gestrick 30 dargestellt, das sich zur Herstellung einer zweiten Ausführungsform eines erfindungsgemäßen Schutzschlauchs eignet. Insbesondere sind die Maschen 32 des Gestricks 30 in Längsrichtung L des Schutzschlauchs länglich ausgebildet, wobei die in Längsrichtung L des Schutzschlauchs verlaufenden Maschenabschnitte 32a zueinander im Wesentlichen parallel verlaufen und erheblich länger bemessen sind als die in Umfangsrichtung U des Schutzschlauchs verlaufenden Maschenabschnitte 32b.

## Patentansprüche

1. In seinem Durchmesser elastisch aufweitbarer Schutzschlauch (20) mit elektromagnetischer Abschirmung, der unter Verwendung von Fäden (22, 24) hergestellt ist, welche zumindest teilweise aus elektrisch leitfähigem Material hergestellt sind,
wobei der Schutzschlauch (20) geflochten ist,
**dadurch gekennzeichnet, dass** er mit einer Schicht (28) aus einem elastisch dehnbaren Material ummantelt ist, und wobei die Ummantelung (28) aus dem elastisch dehnbaren Material den Fäden (22, 24) zumindest an deren der Außenumfangsfläche des Schlauches (20) zugewandter Seite anhaftet, und zwar derart, dass die Fäden an den Stellen, an denen sie sich gegenseitig berühren, derart miteinander verklebt sind, dass sie beim Aufweiten zuverlässig miteinander in Kontakt gehalten bleiben,
dass die Ummantelung (28) aus dem elastisch dehnbaren Material durchbrechungsfrei ausgebildet ist,
dass der Flechtwinkel (α) weniger als 45° beträgt,
dass die Reißdehnbarkeit des elastisch dehnbaren Materials mehr als 200% beträgt, und
dass wenigstens einer der Fäden (22, 24) eine Mehrzahl von Fasern umfasst, von denen wenigstens einige aus elektrisch leitfähigem Material hergestellt sind, wobei die Fasern dazu eingerichtet sind, dass sich die Fasern zweier aneinander anliegender Fäden derart anordnen, dass beide Fäden eine abgeflachte Querschnittsfläche aufweisen, so dass sich die Anzahl der einander berührenden Fasern erhöht, was sich wiederum auf das Zirkulieren der durch die elektromagnetischen Störeffekte induzierten Wirbelströme und somit auf die Abschirmwirkung positiv auswirkt.

2. Schutzschlauch nach Anspruch 1,
**dadurch gekennzeichnet, dass** wenigstens ein Faden oder/und wenigstens eine Faser aus Kupfer oder verzinntem Kupfer hergestellt sind.

3. Schutzschlauch nach Anspruch 1 oder 2,
**dadurch gekennzeichnet, dass** wenigstens ein Faden oder/und wenigstens eine Faser aus Aluminium hergestellt sind.

## Claims

1. Protective hose (20) with electromagnetic shielding, said hose being elastically expandable in its diameter, which is manufactured using threads (22, 24) made at least partially of electrically conductive material,
wherein the protective hose (20) is braided,
**characterised in that** it is sheathed with a layer (28) of an elastically expandable material, wherein the sheath (28) of the elastically expandable material adheres to the thread (22, 24) at least on its side facing towards the outer circumferential surface of the hose (20), and specifically so that the threads are bonded to one another at the points where they contact one another in such a way that they remain reliably in contact with one another during expansion,
that the sheath (28) of the elastically expandable material is formed free of perforations, that the braiding angle (α) is less than 45° is
that the elongation at break of the elastically stretchable material is more than 200%, and
that at least one of the threads (22, 24) comprises a plurality of fibres, at least some of which are made of electrically conductive material, wherein the fibres are configured such that the fibres of two adjacent threads are arranged in such a way that both threads have a flattened cross-sectional area, so that the number of fibres in contact with each other increases, which in turn has a positive effect on the circulation of the eddy currents induced by the electromagnetic interference effects and thereby on the shielding effect.

2. Protective hose according to claim 1,
**characterised in that** at least one thread and/or at least one fibre is/are made of copper or tin-plated copper.

3. Protective hose according to claim 1 or 2,
**characterised in that** at least one thread and/or at least one fibre is/are made of aluminium.

## Revendications

1. Tuyau de protection (20) ayant un diamètre élastiquement expansible et muni d'un blindage électromagnétique, qui est fabriqué en utilisant des fils (22, 24) qui sont fabriqués au moins partiellement en un matériau électriquement conducteur,
le tuyau de protection (20) étant tressé,
**caractérisé en ce que**
il est enveloppé d'une couche (28) en un matériau élastiquement extensible, et l'enveloppe (28) en matériau élastiquement extensible adhère aux fils (22, 24) au moins sur leur côté tourné vers la surface périphérique extérieure du tuyau (20), et ceci de telle sorte que les fils sont collés les uns aux autres aux endroits où ils se touchent mutuellement, de telle sorte qu'ils restent en contact les uns avec les autres de manière fiable lors de l'expansion,
**en ce que** l'enveloppe (28) en matériau élastiquement extensible est réalisée de façon ininterrompue,
**en ce que** l'angle de tressage (α) est inférieur à 45°,
**en ce que** l'extensibilité à la rupture du matériau élastiquement extensible est supérieure à 200 %, et
**en ce que** l'un au moins des fils (22, 24) comprend une pluralité de fibres, dont au moins certaines sont réalisées en un matériau électriquement conducteur, les fibres étant conçues de telle sorte que les fibres de deux fils adjacents se placent de telle sorte que les deux fils présentent une surface de section transversale aplatie, de sorte que le nombre de fibres qui se touchent augmente, ce qui a à son tour un effet positif sur la circulation des courants de Foucault, induits par les effets perturbateurs électromagnétiques, et donc sur l'effet de blindage.

2. Tuyau de protection selon la revendication 1,
**caractérisé en ce qu'**au moins un fil ou/et au moins une fibre sont fabriqués en cuivre ou en cuivre étamé.

3. Tuyau de protection selon la revendication 1 ou 2,
**caractérisé en ce qu'**au moins un fil ou/et au moins une fibre sont fabriqués en aluminium.
